(19) **Europäisches Patentamt European Patent Office Office européen des brevets**

(11) **EP 4 674 897 A1**

(12) **EUROPEAN PATENT APPLICATION**
published in accordance with Art. 153(4) EPC

(43) Date of publication:
07.01.2026 Bulletin 2026/02

(21) Application number: 24763775.4

(22) Date of filing: 22.02.2024

(51) International Patent Classification (IPC):
$C08J\ 5/18^{(2006.01)}$    $B32B\ 17/10^{(2006.01)}$
$B32B\ 27/34^{(2006.01)}$    $C08K\ 3/38^{(2006.01)}$
$C08L\ 79/08^{(2006.01)}$    $H05K\ 1/03^{(2006.01)}$
$H05K\ 3/28^{(2006.01)}$

(52) Cooperative Patent Classification (CPC):
B32B 17/10; B32B 27/34; C08J 5/18; C08K 3/38;
C08L 79/08; H05K 1/03; H05K 3/28

(86) International application number:
PCT/JP2024/006503

(87) International publication number:
WO 2024/181294 (06.09.2024 Gazette 2024/36)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 27.02.2023 JP 2023027913

(71) Applicant: I.S.T Corporation
Otsu-shi, Shiga 520-2153 (JP)

(72) Inventors:
• MATSUBAYASHI, Hidetada
Otsu-shi, Shiga 520-2153 (JP)
• MORIUCHI, Koji
Otsu-shi, Shiga 520-2153 (JP)

(74) Representative: TBK
Bavariaring 4-6
80336 München (DE)

(54) **FILM, LAMINATE AND PRECURSOR COMPOSITION, AND COMPOSITION FOR LOWERING THERMAL EXPANSION COEFFICIENT OF POLYIMIDE RESIN**

(57) The objective of the present invention is to lower a coefficient of thermal expansion of a polyimide film having a relatively high coefficient of thermal expansion. The film according to the present invention contains a polyimide and an oxide containing a boron element. The oxide containing the boron element is preferably obtained from a boric acid and alumina sol. Furthermore, the film preferably has a coefficient of thermal expansion of 50 ppm/°C or less. Furthermore, the film preferably exhibits a light transmittance of 74 % or more at wavelengths of 420nm. In addition, the film preferably exhibits a yellowness index (YI) of 6.0 or less. Furthermore, the film preferably exhibits a thermal conductivity in the range 0.231 W/mK or more and 0.275 W/mK or less.

EP 4 674 897 A1

## Description

### TECHNICAL FIELD

The present invention relates to a film having a low coefficient of thermal expansion. The present invention also relates to a laminate of the film and a glass plate. The invention also relates to a precursor composition required for the preparation of the films. The present invention also relates to a composition for lowering a coefficient of thermal expansion of a polyimide resin.

### BACKGROUND ART

A polyimide resin has been attracting attention as a material having high heat resistance, light weight and flexibility. The polyimide resin is a chemical material indispensable for electronic devices such as personal computers, smartphones, automobiles, and televisions at present. A film (or membrane) made of polyimide resin (hereinafter referred to as "polyimide film") is used as a base film of a flexible printed wiring board, an interlayer insulating film of a semiconductor, or the like which requires high thermal dimensional stability.because it has both heat resistance and insulation.

Although the coefficient of thermal expansion of a polyimide film is generally said to be about 20 ppm/°C, this is merely the coefficient of thermal expansion of a polyimide film having a specific chemical constitution. Among polyimide films, there are characteristic polyimide films such as colorless and transparent polyimide films and polyimide films having excellent adhesion, and many of such polyimide films have a coefficient of thermal expansion exceeding 50 ppm/°C. In recent years, such a characteristic polyimide film has been attracting attention in the production of flexible printed wiring boards, semiconductors, and the like, but its use has been refrained from because of its large coefficient of thermal expansion. This is because, when a polyimide film having a coefficient of thermal expansion exceeding 50 ppm/°C is used in the production of flexible printed circuit boards, semiconductors, and the like, warpage, interfacial peeling, and the like are likely to occur in the flexible printed circuit boards, semiconductors, and the like.

In such a situation, instead of the above-described characteristic polyimide film, a film made of a liquid crystal polymer having a lower coefficient of thermal expansion and a smaller dimensional change than the coefficient of thermal expansion of the characteristic polyimide film, or the like is used. However, the film made of the liquid crystal polymer has a disadvantage that it is inferior in heat resistance and processability to the polyimide film.

### PRIOR ART DOCUMENT

### PATENT DOCUMENT

Patent Document 1: Japanese Patent Application Publication No. 2000 - 343610

### SUMMARY OF THE INVENTION

### PROBLEM TO BE SOLVED BY THE INVENTION

The objective of the present invention is to lower the coefficient of thermal expansion of a polyimide film having a relatively high coefficient of thermal expansion.

### MEANS FOR SOLVING THE PROBLEM

A film according to one aspect of the present invention includes a polyimide resin and an oxide containing a boron element. The film may consist of a polyimide resin and an oxide containing boron. The oxide containing a boron element is preferably obtained from a boric acid and alumina sol. The alumina sol contains alumina (aluminum oxide), and the alumina is mainly composed of an aluminum element and an oxygen element. The oxide containing a boron element is preferably an oxide containing a boron element and an aluminum element. Further, the oxide containing a boron element is preferably dispersed in a matrix of the polyimide resin. The polyimide resin is preferably a main component of the film.

The film preferably has a coefficient of thermal expansion of 50 ppm/°C or less when the thickness of the film is 25 $\mu$m.

The light transmittance of the film at the 420nm wavelength is preferably 74% or more when the thickness is 25 $\mu$m.

The yellowness index (YI) of the film is preferably 6.0 or less when the thickness of the film is 25 $\mu$m.

The thermal conductivity of the film is preferably in the range of 0.231 W/mK or more and 0.275 W/mK or less.

The polyimide resin is preferably obtained by imidizing a polyamic acid composed of an acid dianhydride and a diamine. In this case, the boric acid is preferably added in an amount of 2.0 mass% or more and 20.0 mass% or less based on the solid content of the solution of the polyamic acid. In this case, it is preferable that alumina sol is further added to the solution, and the ratio of the mass of the solid content of the alumina sol to the mass of boric acid is in the range of 0.5 or more and 1.5 or less.

In the above- described film, it is preferable that the blending percentage of the boron element to the total amount is in a range of 0.5 mass% or more and 1.6 mass% or less, and the blending percentage of the aluminum element to the total amount is in a range of 1.5 mass% or more and 4.6 mass% or less.

A laminate according to another aspect of the present invention includes a glass plate and the above- described film.

A precursor composition according to still another aspect of the present invention includes a polyamic acid, a boric acid, and an alumina sol.

A composition for lowering a coefficient of thermal expansion of a polyimide r esin according to still another aspect of the present invention includes a boric ac id and an alumina sol as active ingredients. The composition for lowering the co efficient of thermal expansion may include a polyamic acid.

The present invention can also be expressed as follows.

A composition for lowering a coefficient of thermal expansion of a polyimide r esin including a boric acid and an alumina sol. The composition for lowering the coefficient of thermal expansion may include a polyamic acid.

A method of lowering a coefficient of thermal expansion of a polyimide resin o btained by adding a boric acid and an alumina sol to a polyamic acid solution an d then heating the polyamic acid solution.

Use of a boric acid and an alumina sol for preparation of a composition for lo wering a coefficient of thermal expansion of a polyimide resin. The composition f or lowering the coefficient of thermal expansion may contain a polyamic acid.

Use of a polyamic acid solution including a boric acid and an alumina sol for producing a composition for lowering a coefficient of thermal expansion of a poly imide resin.

Use of a boric acid and an alumina sol for lowering a coefficient of thermal ex pansion of polyimide resin.

A boric acid and an alumina sol used as a coefficient of thermal expansion lo wering agent for polyimide resin.

## EFFECTS OF THE INVENTION

The film according to the present invention includes a polyimide resin and an oxide containing a boron element, and exhibits a lower coefficient of thermal expansion than a polyimide film composed only of the same polyimide resin. In particular, when the thickness of the film is 25 $\mu$m, the coefficient of thermal expansion of the film can be 50 ppm/°C or less. In addition, in a case where the polyimide resin is a polyimide resin constituting a film having excellent colorless transparency, the coefficient of thermal expansion of the film can be decreased while suppressing a decrease in light transmittance and an increase in yellowness index (YI) of the film.

## DETAILED DESCRIPTION OF THE INVENTION

The film according to the embodiment of the present invention is mainly composed of a polyimide resin and an oxide containing a boron element. Here, the polyimide resin is preferably a main component of the film. The oxide containing a boron element is preferably dispersed in a matrix of the polyimide resin. The polyimide resin is obtained by heating and imidizing a polyamic acid solution composed of an acid dianhydride and a diamine. The oxide containing a boron element is formed in the polyimide resin by mixing a boric acid and alumina sol in a polyamic acid solution and heating the mixture. That is, the film according to the embodiment of the present invention includes a boron element and an aluminum element. The boron element can be detected by, for example, ICP emission spectrometry, ICP mass spectrometry, methylene blue absorptiometry, azomethine H absorptiometry, energy dispersive X-ray fluorescence spectrometry, graphite furnace atomic absorption spectrometry, or the like. The aluminum element can be detected by, for example, X-ray diffraction, X-ray photoelectron spectroscopy, X-ray fluorescence analysis, ICP emission spectrometry, atomic absorption spectrometry, infrared spectroscopy, or the like.

In the film according to the embodiment of the present invention, the blending percentage of the boron element to the total amount of the film is preferably in a range of 0.5 mass% or more and 1.6 mass% or less, and the blending percentage of the aluminum element to the total amount is preferably in a range of 1.5 mass% or more and 4.6 mass% or less, the blending percentage of the boron element to the total amount of the film is more preferably in a range of 0.7 mass% or more and 1.6 mass% or less, and the blending percentage of the aluminum element to the total amount is more preferably in a range of 2.0 mass% or more and 4.3 mass% or less, and the blending percentage of the boron element to the total amount of the film is more preferably in a range of 0.8 mass% or more and 1.5 mass% or less, and the blending percentage of the aluminum element to the total amount is more preferably in a range of 2.3 mass% or more and 4.1 mass% or less.

Examples of the method for mixing a boric acid and an alumina sol with a polyamic acid solution include (a) a method of directly mixing the boric acid and the alumina sol with the polyamic acid solution, and (b) a method of adding the boric acid and the alumina sol to an organic solvent to prepare a solution and then adding the solution to the polyamic acid solution.

The purity of a boric acid used for the production of the film according to the embodiment of the present invention is preferably 99.5 % or more. The alumina sol preferably has a solid content of 10 mass% or more. The purity of boric acid and the solid content of alumina sol can be appropriately selected depending on the coefficient of thermal expansion, light transmittance, and yellowness index (YI) of the intended film. The amount of boric acid added relative to the solids content of the polyamic acid solution is preferably in the range of 1.0 mass% or more and 30.0 mass% or less, more preferably in the range of 2.0 mass% or more and 20.0 mass% or less, and even more preferably in the range of 3.0 mass% or more and 10.0 mass% or less.

In the production of the film according to the embodiment of the present invention, the mass ratio of the solid content of the alumina sol to boric acid is preferably in the range of 0.5 or more and 1.5 or less, and more preferably in the range of 0.6 or more and 0.9 or less.

The film according to the embodiment of the present invention can be obtained by adding boric acid and alumina sol to the above- described polyamic acid solution (hereinafter, sometimes referred to as an additive-containing polyamic acid solution) and heat molding the additive-containing polyamic acid solution with a known method. For example, the film according to the embodiment of the present invention can be produced by applying the additive-containing polyamic acid solution onto a support, drying the coating film, and heating the dried coating film.

Examples of the acid dianhydride that can be used for preparing the polyamic acid solution according to the embodiment of the present invention include aromatic tetracarboxylic dianhydride such as pyromellitic dianhydride (PMDA), 1,2,5,6-naphthalenetetracarboxylic dianhydride, 1,4,5,8-naphthalenetetracarboxylic dianhydride, 2,3,6,7-naphthalenetetracarboxylic dianhydride, 2,2',3,3'-biphenyltetracarboxylic dianhydride, 2,3,3'4'-biphenyltetracarboxylic dianhydride, 3,3',4,4'-biphenyltetracarboxylic dianhydride (BPDA), 2,2',3,3'-benzophenonetetracarboxylic dianhydride, 2,3,3',4'-benzophenonetetracarboxylic dianhydride, 3,3',4,4'-benzophenonetetracarboxylic dianhydride (BTDA), bis (3,4-dicarboxyphenyl) sulfone dianhydride, bis (2,3-dicarboxyphenyl) methane dianhydride, bis (3,4-dicarboxyphenyl) methane dianhydride, 1,1-bis (2,3-dicarboxyphenyl) ethane dianhydride, 1,1-bis (3,4-dicarboxyphenyl) ethane dianhydride, 2,2-bis [3,4-(dicarboxyphenoxy) phenyl] propane dianhydride (BPADA), 4,4'-(hexafluoroisopropylidene) diphthalic anhydride, oxydiphthalic anhydride (ODPA), bis (3,4-dicarboxyphenyl) sulfone dianhydride, bis (3,4-dicarboxyphenyl) sulfoxide dianhydride, thiodiphthalic dianhydride, 3,4,9,10-perylenetetracarboxylic dianhydride, 2,3,6,7-anthracenetetracarboxylic dianhydride, 1,2,7,8-phenanthrenetetracarboxylic dianhydride, 9,9-bis (3,4-dicarboxyphenyl) fluorene dianhydride, 9,9-bis [4-(3,4'-dicarboxyphenoxy) phenyl] fluorene dianhydride, and the like, and cyclobutanetetracarboxylic dianhydride, 1,2,3,4-cyclopentanetetracarboxylic dianhydride, 2,3,4,5-tetrahydrofurantetracarboxylic dianhydride, 1,2,4,5-cyclohexanetetracarboxylic dianhydride, 3,4-dicarboxy-1-cyclohexylsuccinic dianhydride, 3,4-dicarboxy-1,2,3,4-tetrahydro-1-naphthalenesuccinic dianhydride, 4,5'-oxybis (isobenzofuran-1,3-dione), 5,5-[1,4-phenylene-bis(oxy)]bis(isobenzofuran-1,3-dione), 4,4'-[2,1-phenylenebis(oxy)]bis(isobenzofuran-1,3-dione), 3,3'-(p-phenylenedioxy) diphthalic anhydride, 5,5'-[1,2-phenylenebis (oxy) bis (isobenzofuran-1,3-dione), 5,5'-[1,3-phenylenebis (oxy) bis (isobenzofuran-1,3-dione), 4,4'-[m-phenylenebis (oxy) bis (isobenzofuran-1,3-dione), 4,5'-[1,4-phenylenebis (oxy) bis (isobenzofuran-1,3-dione), and 1,4-bis (dicarboxyphenoxy) benzene dianhydride. These acid dianhydrides may be used in combination of two or more.

Examples of diamines that can be used in the preparation of the polyamic acid solution according to the embodiments of the present invention include aromatic diamines such as para-phenylenediamine (PPD), meta-phenylenediamine (MPDA), 2,5-diaminotoluene, 2,6-diaminotoluene, 4,4'-diaminobiphenyl, 3,3'-dimethyl-4,4'-diaminobiphenyl, 3,3'-dimethoxy-4,4'-diaminobiphenyl, 2,2-bis (trifluoromethyl)-4,4'-diaminobiphenyl, 3,3'-diaminodiphenylmethane, 4,4'-diaminodiphenylmethane (MDA), 2,2-bis-(4-aminophenyl) propane, 3,3'-diaminodiphenylsulfone (33DDS), 4,4'-diaminodiphenylsulfone (44DDS), diaminobenzotrifluoride, bis (trifluoromethyl) phenylenediamine, diaminotetra (trifluoromethyl) benzene, diamino (pentafluoroethyl) benzene, 2,2'-bis (trifluoromethyl) benzidine (TFMB), 3,3'-bis (trifluoromethyl) benzidine, 2,2'-bis (trifluoromethyl)-4,4'-diaminodiphenylether, 3,3'-bis (trifluoromethyl)-4,4'-diaminodiphenylether, 3,3',5,5'-tetrakis (trifluoromethyl)-4,4'-diaminodiphenylether, 3,3'-bis (trifluoromethyl)-4,4'-diaminobenzophenone, bis (aminophenoxy) di (trifluoromethyl) benzene, bis (aminophenoxy) tetrakis (trifluoromethyl) benzene, bis [(trifluoromethyl) aminophenoxy] benzene, bis [(trifluoromethyl) aminophenoxy] benzene, bis [(trifluoromethyl) aminophenoxy] biphenyl, bis {[(trifluoromethyl) aminophenoxy]phenyl} hexafluoropropane, 2,2-bis {4-(p-aminophenoxy) phenyl} hexafluoropropane, 2,2-bis {4-(m-aminophenoxy) phenyl} hexafluoropropane, 2,2-bis {4-(o-aminophenoxy) phenyl} hexafluoropropane, 2-{4-(p-aminophenoxy) phenyl}-2-{4-(m-aminophenoxy) phenyl} hexafluoropropane, 2-{4-(m-aminophenoxy) phenyl}-2-{4-(o-aminophenoxy) phenyl} hexafluoropropane, 2-{4-(o-aminophenoxy) phenyl}-2-{4-(p-aminophenoxy) phenyl} hexafluoropropane, 3,3'-diaminodiphenyl sulfide, 4,4'-diaminodiphenyl sulfide, 3,3'-diaminodiphenyl ether, 3,4'-diaminodiphenyl ether (34ODA), 4,4'-diaminodiphenyl ether (ODA), 1,5-diaminonaphthalene, 4,4'-diaminodiphenyldiethylsilane, 4,4'-diaminodiphenylsilane, 4,4'-diaminodiphenylethylphosphine oxide, 1,3-bis (3-aminophenoxy) benzene (133APB), 1,3-bis(4-aminophenoxy)benzene (134APB), 1,4-bis(4-aminophenoxy)benzene, bis [4-(3-aminophenoxy) phenyl] sulfone (BAPSM), bis [4-(4-aminophenoxy) phenyl] sulfone (BAPS), 2,2-bis [4-(4-aminophenoxy) phenyl] propane (BAPP), 2,2-bis (3-aminophenyl) 1,1,1,3,3,3-hexafluoropropane, 2,2-bis (4-aminophenyl) 1,1,1,3,3,3-hexafluoropropane, 9,9-bis(4-aminophenyl)fluorene, and the like. These diamines may be used in combination of two or more.

From the viewpoint of imparting mechanical properties such as durability (for example, bending durability) to the film according to the embodiment of the present invention, it is preferable to employ 3,3',4,4'-biphenyltetracarboxylic dianhydride as the acid dianhydride and p-phenylenediamine as the diamine, or to employ 3,3',4,4'-biphenyltetracarboxylic dianhydride as the acid dianhydride and 4,4'-diaminodiphenyl ether as the diamine. In addition, from the viewpoint of imparting the film according to the embodiment of the present invention with, for example, transparency as a display component or the like, it is preferable to employ 3,3',4,4'-biphenyltetracarboxylic dianhydride and 2,2-bis [3,4-(dicarboxyphenoxy) phenyl] propane dianhydride (BPADA) as the dianhydride, and to employ 2,2'-bis (trifluoromethyl) benzidine (TFMB) and 3,3'-diaminodiphenyl sulfone (33DDS) as the diamine. In addition, other acid dianhydrides and other diamines may be added to the acid dianhydride and the diamine described above within a range not impairing the gist of the present invention.

When the thickness of the film according to the embodiment of the present invention is 25 $\mu$m, the coefficient of thermal expansion of the film is preferably 50 ppm/°C or less. The coefficient of thermal expansion is more preferably 45 ppm/°C or less, still more preferably 44 ppm/°C or less, yet still more preferably 43 ppm/°C or less, yet still more preferably 42 ppm/°C or less, yet still more preferably 41 ppm/°C or less, and particularly preferably 40 ppm/°C or less. The lower limit value is 17 ppm/°C. The lower limit value thereof may be 20 ppm/°C, 25 ppm/°C, 30 ppm/°C, 35 ppm/°C, or 39 ppm/°C. The coefficient of thermal expansion can be made appropriate for the application and the base material (mating material) by adjusting the addition amounts of the boric acid and the alumina sol.

When the thickness of the film according to the embodiment of the present invention is 25 $\mu$m, the light transmittance of the film at 420 nm wavelength is preferably 74 % or more. The light transmittance is more preferably 75 % or more, still more preferably 76 % or more, yet still more preferably 77 % or more, yet still more preferably 78 % or more, and particularly preferably 79 % or more. The upper limit value is 100 %. The film having such a light transmittance exhibits a low coefficient of thermal expansion and can be suitably used for display applications and the like.

Further, when the thickness of the film according to the embodiment of the present invention is 25 $\mu$m, the yellowness index (YI) of the film is preferably 6.0 or less. The yellowness index is more preferably 5.0 or less, still more preferably 4.5 or less, still more preferably 4.0 or less, and particularly preferably 3.5 or less. The lower limit value is 2.0. The lower limit value may be 2.5 or 3.0. The film having such a yellow index exhibits a low coefficient of thermal expansion, and can be suitably used for display applications and the like.

The tensile strength of the film according to the embodiment of the present invention is preferably in the range of 50 MPa or more and 250 MPa or less. The tensile strength is more preferably in the range of 100 MPa or more and 200 MPa or less. The film according to the embodiment of the present invention can exhibit a tensile strength comparable to the tensile strength inherent in a polyimide film while exhibiting a low coefficient of thermal expansion by including an oxide containing a boron element.

Further, the tensile modulus of the film according to the embodiment of the present invention is preferably in the range of 3.0 GPa or more and 5.0 GPa or less. The tensile modulus is more preferably in the range of 3.5 GPa or more and 4.5 GPa or less. The film according to the embodiment of the present invention can exhibit a tensile elastic modulus equal to or higher than the tensile elastic modulus that the polyimide film originally has, while exhibiting a low coefficient of thermal expansion by including the oxide containing a boron element.

The tensile elongation of the film according to the embodiment of the present invention is preferably in the range of 10 % or more and 40 % or less. The tensile elongation is more preferably in the range of 13 % or more and 35 % or less.

Further, the thermal conductivity of the film according to the embodiment of the present invention is preferably in the range of 0.231 W/mK or more and 0.275 W/mK or less. The thermal conductivity is more preferably in the range of 0.231 W/mK or more and 0.243 W/mK or less. The thermal conductivity may be in the range of 0.240 W/mK or more and 0.275 W/mK or less, more preferably in the range of 0.245 W/mK or more and 0.275 W/mK or less, still more preferably in the range of 0.250 W/mK or more and 0.275 W/mK or less, still more preferably in the range of 0.255 W/mK or more and 0.275 W/mK or less, and particularly preferably in the range of 0.260 W/mK or more and 0.275 W/mK or less.

<WORKING EXAMPLES AND COMPARATIVE EXAMPLES>

Hereinafter, the present invention will be described in more detail with reference to WORKING EXAMPLEs and COMPARATIVE EXAMPLEs, but the present invention is not limited to the WORKING EXAMPLEs.

**WORKING EXAMPLE 1**

1. Preparation of Additive-Containing Polyamic Acid Solution

12.07 g of biphenyltetracarboxylic dianhydride (BPDA), 5.34 g of 2,2-bis [3,4-(dicarboxyphenoxy) phenyl] propane dianhydride (BPADA), 8.22 g of 2,2'-bis (trifluoromethyl) benzidine (TFMB) and 6.37 g of 3,3'-diaminodiphenyl sulfone (33DDS) were reacted in 74.5 g of N,N-dimethylacetamide (DMAc) to prepare a polyamic acid solution with 30 mass% solid content.

Next, to 26.5 g of N,N-dimethylacetamide (DMAc) were added 2.56 g of 99.5 % pure boric acid (manufactured by Nacalai Tesque, Inc.) and 11.18 g of alumina sol (solid content 20.0 wt%, manufactured by Nissan Chemical Industries, Ltd.) to obtain a mixed solution of boric acid and alumina sol (hereinafter simply referred to as "mixed solution"). The mixed solution was added to the polyamic acid solution to prepare an additive-containing polyamic acid solution.

2. Formation of Film

The additive-containing polyamic acid solution was applied onto a glass plate to form a coating, and the coating was then placed in an oven at 80 °C and dried for 15 minutes to obtain a precursor film. Next, the precursor film was peeled off from the glass plate, and then the precursor film was placed in an oven at a temperature of 180 °C and maintained for 10 minutes in a state where the end portion of the precursor film was fixed by a frame body. Thereafter, the temperature of the oven was raised to 280 °C. At this time, the temperature of the oven was raised from 180 °C to 280 °C over 22 minutes, and after the temperature of the oven reached 280 °C, the temperature was maintained for 5 minutes. As a result, a film was formed on the glass substrate. Thereafter, the jig that fixed the end of the film was removed to obtain a film having a thickness of 25 $\mu$m.

The boron element in the boric acid, the aluminum element in the alumina sol, the compound containing the boron element, the compound containing the aluminum element, and the compound containing both elements are not volatilized even at 280 °C. Based on this fact, the content percentage of the boron element and the aluminum element with respect to the total amount of the finally obtained film were calculated from the addition amounts of the boric acid and the alumina sol and the solid content concentration of the polyamic acid, and the former was 1.3 mass% and the latter was 3.5 mass%.

3. Measurement of Physical Properties of Film

The coefficient of thermal expansion, light transmittance, yellowness index (YI), tensile strength, tensile elastic modulus, tensile elongation, and thermal conductivity of the obtained film having a thickness of 25 $\mu$m were determined as described below.

(1) Coefficient of Thermal Expansion of Film

The film piece cut out into 3.5 mm x 13.0 mm was fixed to a thermal analyzer (TMA-60) manufactured by Shimadzu Corporation, and then the temperature was raised to 300 °C at a temperature rising rate of 5.0 °C/min, and the dimensional changes of the film with respect to the temperature, that is, a TMA curve was recorded. From the TMA curve obtained, the average coefficient of thermal expansion from 100 °C to 200 °C was determined, and the coefficient of thermal expansion of the film was found to be 40.5ppm/°C (see Table 1).

(2) Light Transmittance of Film

A film piece cut out into 50.0 mm $\times$ 50.0 mm was fixed to a spectrophotometer UV 2550 (Shimadzu Corporation), and then the film was irradiated with light ray of 420 nm wavelength from a deuterium lamp, and as a result, the transmittance of the light ray through the film was 76 % (see Table 1).

(3) Yellow Index (YI) of Film

The film piece cut out into 50.0mm x 50.0mm was fixed to a spectrophotometer UV 2550 (Shimadzu Corporation), and then the yellowness index (YI) of the film was measured, and as a result, the yellowness index (YI) of the film was 4.4 (see Table 1).

(4) Tensile Properties of Film

After setting the distance between the upper chuck and lower chuck of an Autograph AGS-TYPE 10KNG manufactured by Shimadzu Corporation to the 30mm, a film piece punched out with a JIS3 dumbbell (JIS K6301) was fixed to the upper and lower chucks, and the load with respect to the displacement of the upper chucks was measured with load cells while pulling the film piece at a tensile speed of 50 mm/min, thereby recording a stress-strain curve. The tensile strength, tensile modulus and tensile elongation of the film were determined from the obtained stress-strain curve, and the tensile strength of the film was 133 MPa, the tensile modulus was 4.3 GPa and the tensile elongation was 28.6 % (see Table 2).

(5) Thermal Conductivity of Film

A film piece of 2 cm x 2 cm was cut out from the film with reference to JIS R2616. Next, a transistor was provided on one surface of the film piece via a heat conductive grease. Further, an aluminum heat sink was provided on the opposite surface via a heat conductive grease. Then, the temperature of the transistor was raised by applying a current to the transistor until the temperature of the transistor reached 60 °C, and the temperature was maintained at 60 °C for 3 minutes. During this time, the temperature A of the surface of the transistor and the temperature B of the surface of the film piece on the heat sink side were measured using a thermocouple. In addition, the power consumption at that time was measured. Subsequently, the temperatures A and B of the respective surfaces and the power consumption were substituted into the following formula to calculate the thermal resistance.

Thermal resistance = (temperature A of transistor surface - temperature B of surface of film piece on heat sink side) / power consumption

Finally, the thermal resistance obtained as described above, the thickness of the film piece, and the cross-sectional area of the transistor were substituted into the following formula to calculate the target thermal conductivity.

Thermal conductivity = thickness of film piece / (cross-sectional area of transistor x thermal resistance)

As a result, the thermal conductivity of the film was 0. 259 W/mK (see Table 1).

Further, the additive-containing polyamic acid solution was applied onto a glass plate to form a coating, and then the coating was placed in an oven at 80 °C., and after 15 minutes, the oven was heated to 150 °C. At this time, it took 20 minutes for the temperature of the oven to reach 150 °C from 70 °C. After the temperature of the oven reached 150 °C, the temperature was maintained for 10 minutes, and then the temperature of the oven was increased to 300 °C. At this time, it took 25 minutes for the temperature of the oven to reach 300 °C from 150 °C. Once the oven temperature reached 300 °C, it was held at that temperature for 5 minutes. As a result, a film having a thickness of 25 $\mu$m was formed on the glass plate.

The adhesiveness of the film to the glass plate was confirmed, and it was confirmed that the film was favorably adhered to the glass plate.

## WORKING EXAMPLE 2

A target film was obtained in the same manner as in WORKING EXAMPLE 1 except that the amount of alumina sol added was changed from 11.18 g to 12.78 g. The content percentage of the boron element and the aluminum element with respect to the total amount of the film were determined based on the fact described in WORKING EXAMPLE 1, and the former was 1.3 mass% and the latter was 4.0 mass%.

The physical properties of the obtained film were measured by the same methods as shown in WORKING EXAMPLE 1. As a result, the film had a coefficient of thermal expansion of 39.1 ppm/°C, a light transmittance of 74 % at 420 nm wavelength, a yellow index (YI) of 4.8, a tensile strength of 129 MPa, a tensile modulus of 4.2 GPa, a tensile elongation of 27.3 %, and a thermal conductivity of 0.271 W/mK (see Tables 1 and 2).

In addition, a laminate of the film and a glass plate was formed in the same manner as in WORKING EXAMPLE 1, and the adhesiveness of the film to the glass plate was confirmed, whereby it was confirmed that the film was favorably adhered to the glass plate.

## WORKING EXAMPLE 3

A target film was obtained in the same manner as in WORKING EXAMPLE 1 except that the amount of alumina sol added was changed from 11.18 g to 7.99 g. The content percentage of the boron element and the aluminum element with respect to the total amount of the film were determined based on the fact described in WORKING EXAMPLE 1, and the former was 1.3 mass% and the latter was 2.5 mass%.

The physical properties of the obtained film were measured by the same methods as shown in WORKING EXAMPLE 1. As a result, the film had a coefficient of thermal expansion of 41.3 ppm/°C, a light transmittance of 78 % at 420 nm wavelength, a yellow index (YI) of 5.9, a tensile strength of 123 MPa, a tensile modulus of 4.1 GPa, a tensile elongation of 30.0 %, and a thermal conductivity of 0.252 W/mK (see Tables 1 and 2).

In addition, a laminate of the film and a glass plate was formed in the same manner as in WORKING EXAMPLE 1, and the adhesiveness of the film to the glass plate was confirmed, whereby it was confirmed that the film was favorably adhered to the glass plate.

## WORKING EXAMPLE 4

A target film was obtained in the same manner as in WORKING EXAMPLE 1 except that the addition amount of boric acid was changed from 2.56 g to 1.59 g and the addition amount of alumina sol was changed from 11.18 g to 7.99 g. The content percentage of the boron element and the aluminum element with respect to the total amount of the film were determined based on the fact described in WORKING EXAMPLE 1, and the former was 0.9 mass% and the latter was 2.6 mass%.

The physical properties of the obtained film were measured by the same methods as shown in WORKING EXAMPLE 1. As a result, the film had a coefficient of thermal expansion of 43.2 ppm/°C, a light transmittance of 79 % at 420 nm wavelength, a yellow index (YI) of 3.5, a tensile strength of 145 MPa, a tensile modulus of 3.9 GPa, a tensile elongation of 35.0 %, and a thermal conductivity of 0.245 W/mK (see Tables 1 and 2).

In addition, a laminate of the film and a glass plate was formed in the same manner as in WORKING EXAMPLE 1, and the adhesiveness of the film to the glass plate was confirmed, whereby it was confirmed that the film was favorably adhered to the glass plate.

## WORKING EXAMPLE 5

1. Preparation of Additive-Containing Polyamic Acid Solution

11.67 g of biphenyltetracarboxylic dianhydride (BPDA), 5.16 g of 2,2-bis [3,4-(dicarboxyphenoxy) phenyl] propane dianhydride (BPADA), 12.70 g of 2,2'-bis (trifluoromethyl) benzidine (TFMB) and 2.46 g of 3,3'-diaminodiphenyl sulfone (33DDS) were reacted in 74.5 g of N,N-dimethylacetamide (DMAc) to prepare a polyamic acid solution with 30 mass% solid content.

Next, to 26.5 g of N,N-dimethylacetamide (DMAc) were added 1.59 g of 99.5 % pure boric acid (manufactured by Nacalai Tesque, Inc.) and 7.99 g of alumina sol (solid content 20.0 wt%, manufactured by Nissan Chemical Industries, Ltd.) to obtain a mixed solution of boric acid and alumina sol (hereinafter simply referred to as "mixed solution"). The mixed solution was added to the polyamic acid solution to prepare an additive-containing polyamic acid solution.

2. Formation of Film

A target film was obtained in the same manner as in WORKING EXAMPLE 1. The content percentage of the boron element and the aluminum element with respect to the total amount of the film were determined based on the fact described in WORKING EXAMPLE 1, and the former was 0.9 mass% and the latter was 2.6 mass%.

3. Measurement of Physical Properties of Film

The physical properties of the obtained film were measured by the same methods as shown in WORKING EXAMPLE 1. As a result, the film had a coefficient of thermal expansion of 44.5 ppm/°C, a light transmittance of 78 % at 420 nm wavelength, a yellow index (YI) of 5.9, a tensile strength of 123 MPa, a tensile modulus of 4.1 GPa, a tensile elongation of 30.0 %, and a thermal conductivity of 0.243 W/mK (see Tables 1 and 2).

In addition, a laminate of the film and a glass plate was formed in the same manner as in WORKING EXAMPLE 1, and the adhesiveness of the film to the glass plate was confirmed, whereby it was confirmed that the film was favorably adhered to the glass plate.

## WORKING EXAMPLE 6

1. Preparation of Additive-Containing Polyamic Acid Solution

17.85 g of biphenyltetracarboxylic dianhydride (BPDA), 12.15g of 4,4'-diaminodiphenyl ether (ODA) were reacted in 70.0 g of N,N-dimethylacetamide (DMAc) to prepare a polyamic acid solution with 30 mass% solid content.

Next, to 23.0 g of N,N-dimethylacetamide (DMAc) were added 1.50 g of 99.5 % pure boric acid (manufactured by Nacalai Tesque, Inc.) and 7.50 g of alumina sol (solid content 20.0 wt%, manufactured by Nissan Chemical Industries, Ltd.) to obtain a mixed solution of boric acid and alumina sol (hereinafter simply referred to as "mixed solution"). The mixed solution was added to the polyamic acid solution to prepare an additive-containing polyamic acid solution.

2. Formation of Film

A target film was obtained in the same manner as in WORKING EXAMPLE 1. The content percentage of the boron element and the aluminum element with respect to the total amount of the film were determined based on the fact described in WORKING EXAMPLE 1, and the former was 0.9 mass% and the latter was 2.6 mass%.

3. Measurement of Physical Properties of Film

The physical properties of the obtained film were measured by the same methods as shown in WORKING EXAMPLE 1. As a result, the film had a coefficient of thermal expansion of 42.7 ppm/°C, a tensile strength of 158 MPa, a tensile modulus of 4.3 GPa, a tensile elongation of 20.9 %, and a thermal conductivity of 0.245 W/mK (see Tables 1 and 2).
In addition, a laminate of the film and a glass plate was formed in the same manner as in WORKING EXAMPLE 1, and the adhesiveness of the film to the glass plate was confirmed, whereby it was confirmed that the film was favorably adhered to the glass plate.

**WORKING EXAMPLE 7**

1. Preparation of Additive-Containing Polyamic Acid Solution

12.07 g of biphenyltetracarboxylic dianhydride (BPDA), 5.34 g of 2,2-bis [3,4-(dicarboxyphenoxy) phenyl] propane dianhydride (BPADA) 8.22 g of 2,2'-bis (trifluoromethyl) benzidine (TFMB) and 6.37 g of 4,4'-diaminodiphenyl sulfone (44DDS) were reacted in 74.5 g of N,N-dimethylacetamide (DMAc) to prepare a polyamic acid solution with 30 mass% solid content.
Next, to 26.5 g of N, N-dimethylacetamide (DMAc) were added 2.56 g of 99.5 % pure boric acid (manufactured by Nacalai Tesque, Inc.) and 11.18 g of alumina sol (solid content 20.0 wt%, manufactured by Nissan Chemical Industries, Ltd.) to obtain a mixed solution of boric acid and alumina sol (hereinafter simply referred to as "mixed solution"). The mixed solution was added to the polyamic acid solution to prepare an additive-containing polyamic acid solution.

2. Formation of Film

A target film was obtained in the same manner as in WORKING EXAMPLE 1. The content percentage of the boron element and the aluminum element with respect to the total amount of the film were determined based on the fact described in WORKING EXAMPLE 1, and the former was 1.3 mass% and the latter was 3.5 mass%.

3. Measurement of Physical Properties of Film

The physical properties of the obtained film were measured by the same methods as shown in WORKING EXAMPLE 1. As a result, the film had a coefficient of thermal expansion of 45.3 ppm/°C, a light transmittance of 74 % at 420 nm wavelength, a yellow index (YI) of 5.5, a tensile strength of 124 MPa, a tensile modulus of 3.0 GPa, a tensile elongation of 18.8 %, and a thermal conductivity of 0.256 W/mK (see Tables 1 and 2).
In addition, a laminate of the film and a glass plate was formed in the same manner as in WORKING EXAMPLE 1, and the adhesiveness of the film to the glass plate was confirmed, whereby it was confirmed that the film was favorably adhered to the glass plate.

(COMPARATIVE EXAMPLE 1)

1. Preparation of Additive-Containing Polyamic Acid Solution

A polyamic acid solution with 30 mass% solid content was prepared in the same manner as in WORKING EXAMPLE 1.
Next, to 26.5 g of N,N-dimethylacetamide (DMAc) were added 2.56 g of 99.5 % pure boric acid (manufactured by Nacalai Tesque, Inc.) was added to prepare a boric acid solution, and the boric acid solution was added to the above-described polyamic acid solution to prepare a boric acid-containing polyamic acid solution.

2. Formation of Film

A target film was obtained in the same manner as in WORKING EXAMPLE 1 except that the additive-containing polyamic acid solution was replaced with the boric acid-containing polyamic acid solution. The content percentage of the boron element and the aluminum element with respect to the total amount of the film were determined based on the fact described in WORKING EXAMPLE 1, and the former was 1.4 mass% and the latter was 0 mass%.

3. Measurement of Physical Properties of Film

The physical properties of the obtained film were measured by the same methods as shown in WORKING EXAMPLE 1. As a result, the film had a coefficient of thermal expansion of 150 ppm/° C, a light transmittance of 11 % at 420 nm wavelength, a yellow index (YI) of 62, a tensile strength of 113 MPa, a tensile modulus of 3.9 GPa and a tensile elongation of 3.2 % (see Tables 1 and 2).

(COMPARATIVE EXAMPLE 2)

A target film was obtained in the same manner as in WORKING EXAMPLE 1 except that 2.56 g of 99.5 % pure boric acid (manufactured by Nacalai Tesque, Inc.) was replaced with 11.18 g of alumina sol (solid content 20.0 wt%, manufactured by Nissan Chemical Industries, Ltd.). The content percentage of the boron element and the aluminum element with respect to the total amount of the film were determined based on the fact described in WORKING EXAMPLE 1, and the former was 0 mass% and the latter was 3.7 mass%.
The physical properties of the obtained film were measured by the same methods as shown in WORKING EXAMPLE 1. As a result, the film had a coefficient of thermal expansion of 51.0 ppm/° C, a light transmittance of 79 % at 420 nm wavelength, a yellow index (YI) of 3.4, a tensile strength of 141 MPa, a tensile modulus of 3.8 GPa and a tensile elongation of 30.0 % (see Tables 1 and 2).

(COMPARATIVE EXAMPLE 3)

1. Preparation of Polyamic Acid Solution

A polyamic acid solution with 30 mass% solid content was prepared in the same manner as in WORKING EXAMPLE 1.

2. Formation of Film

A target film was obtained in the same manner as in WORKING EXAMPLE 1 except that the additive-containing polyamic acid solution was replaced with the above-described polyamic acid solution. That is, the content percentage of the boron element and the aluminum element with respect to the total amount of the film were both 0 mass%.

3. Measurement of Physical Properties of Film

The physical properties of the obtained film were measured by the same methods as shown in WORKING EXAMPLE 1. As a result, the film had a coefficient of thermal expansion of 51.0 ppm/° C, a light transmittance of 80 % at 420 nm wavelength, a yellow index (YI) of 3.2 (see Tables 1 and 2).

(COMPARATIVE EXAMPLE 4)

1. Preparation of Polyamic Acid Solution

A polyamic acid solution with 30 mass% solid content was prepared in the same manner as in WORKING EXAMPLE 6.

2. Formation of Film

A target film was obtained in the same manner as in WORKING EXAMPLE 1 except that the additive-containing polyamic acid solution was replaced with the above-described polyamic acid solution. That is, the content percentage of the boron element and the aluminum element with respect to the total amount of the film were both 0 mass%.

3. Measurement of Physical Properties of Film

The physical properties of the obtained film were measured by the same methods as shown in WORKING EXAMPLE 1. As a result, the film had a coefficient of thermal expansion of 51.0 ppm/° C (see Tables 1).

(COMPARATIVE EXAMPLE 5)

1. Preparation of Polyamic Acid Solution

A polyamic acid solution with 30 mass% solid content was prepared in the same manner as in WORKING EXAMPLE 7.

2. Formation of Film

A target film was obtained in the same manner as in WORKING EXAMPLE 1 except that the additive-containing polyamic acid solution was replaced with the above-described polyamic acid solution. That is, the content percentage of the boron element and the aluminum element with respect to the total amount of the film were both 0 mass%.

3. Measurement of Physical Properties of Film

The physical properties of the obtained film were measured by the same methods as shown in WORKING EXAMPLE 1. As a result, the film had a coefficient of thermal expansion of 55.7 ppm/° C, a light transmittance of 78 % at 420 nm wavelength, a yellow index (YI) of 4.6 (see Tables 1 and 2).

[Table 1]

| | Monomer Composition Of Polyamic Acid | Additives | | CTE (ppm/°C) | Light Transmission@420nm (%) | YI | Thermal Conductivity (W/mK) |
|---|---|---|---|---|---|---|---|
| | | Boric Acid | Alumina Sol | | | | |
| W. Ex. 1 | BPDA/BPADA//TFMB/33DDS | Contained | Contained | 40.5 | 76 | 4.4 | 0.259 |
| W. Ex. 2 | BPDA/BPADA//TFMB/33DDS | Contained | Contained | 39.1 | 74 | 4.8 | 0.271 |
| W. Ex. 3 | BPDA/BPADA//TFMB/33DDS | Contained | Contained | 41.3 | 78 | 5.9 | 0.252 |
| W. Ex. 4 | BPDA/BPADA//TFMB/33DDS | Contained | Contained | 43.2 | 79 | 3.5 | 0.245 |
| W. Ex. 5 | BPDA/BPADA//TFMB/33DDS | Contained | Contained | 44.5 | 78 | 5.9 | 0.243 |
| W. Ex. 6 | BPDA/ODA | Contained | Contained | 42.7 | --- | --- | 0.245 |
| W. Ex. 7 | BPDA/BPADA//TFMB/44DDS | Contained | Contained | 45.3 | 74 | 5.5 | 0.256 |
| C. Ex. 1 | BPDA/BPADA//TFMB/33DDS | Contained | Not Contained | 150 | 11 | 62 | --- |
| C. Ex. 2 | BPDA/BPADA//TFMB/33DDS | Not Contained | Contained | 51.0 | 79 | 3.4 | --- |
| C. Ex. 3 | BPDA/BPADA//TFMB/33DDS | Not Contained | Not Contained | 51.0 | 80 | 3.2 | --- |
| C. Ex. 4 | BPDA/ODA | Not Contained | Not Contained | 51.0 | --- | --- | --- |
| C. Ex. 5 | BPDA/BPADA//TFMB/44DDS | Not Contained | Not Contained | 55.7 | 78 | 4.6 | --- |

EP 4 674 897 A1

[Table 2]

| | Monomer Composition Of Polyamic Acid | Additives | | Tensile Properties | | |
|---|---|---|---|---|---|---|
| | | Boric Acid | Alumina Sol | Strength (MPa) | Modulus (GPa) | Elongation (%) |
| W. Ex. 1 | BPDA/BPADA//TFMB/33DDS | Contained | Contained | 133 | 4.3 | 28.6 |
| W. Ex. 2 | BPDA/BPADA//TFMB/33DDS | Contained | Contained | 129 | 4.2 | 27.3 |
| W. Ex. 3 | BPDA/BPADA//TFMB/33DDS | Contained | Contained | 123 | 4.1 | 30.0 |
| W. Ex. 4 | BPDA/BPADA//TFMB/33DDS | Contained | Contained | 145 | 3.9 | 35.0 |
| W. Ex. 5 | BPDA/BPADA//TFMB/33DDS | Contained | Contained | 123 | 4.1 | 30.0 |
| W. Ex. 6 | BPDA/ODA | Contained | Contained | 158 | 4.3 | 20.9 |
| W. Ex. 7 | BPDA/BPADA//TFMB/44DDS | Contained | Contained | 124 | 3.0 | 18.8 |
| C. Ex. 1 | BPDA/BPADA//TFMB/33DDS | Contained | Not Contained | 113 | 3.9 | 3.2 |
| C. Ex. 2 | BPDA/BPADA//TFMB/33DDS | Not Contained | Contained | 141 | 3.8 | 30.0 |
| C. Ex. 3 | BPDA/BPADA//TFMB/33DDS | Not Contained | Not Contained | --- | --- | --- |
| C. Ex. 4 | BPDA/ODA | Not Contained | Not Contained | --- | --- | --- |
| C. Ex. 5 | BPDA/BPADA//TFMB/44DDS | Not Contained | Not Contained | --- | --- | --- |

From the results shown in the above WORKING EXAMPLEs and COMPARATIVE EXAMPLEs, it was revealed that the films obtained in the present WORKING EXAMPLEs have a suppressed coefficient of thermal expansion as compared with the polyimide film to which boric acid, alumina sol, or both of them are not added. It was also found that the films obtained in the present WORKING EXAMPLEs exhibited tensile properties equivalent to those of polyimide films to which boric acid, alumina sol, or both were not added. It was also found that the films obtained in WORKING EXAMPLEs 1 to 5 exhibited colorless transparency equivalent to those of polyimide films to which neither boric acid nor alumina sol was added.

## INDUSTRIAL APPLICABILITY

The film according to the present invention exhibits a lower coefficient of thermal expansion than a polyimide film composed only of the same polyimide resin, and can be used as, for example, a substrate, a board, a coverlay and the like that make up component or member of an electrical device or an electronic device, a heat-resistant tape, a solar cell (for example, a silicon solar cell, a perovskite solar cell, or the like). Examples of the substrate include a circuit substrate for mounting a light emitting element and a substrate for printing a barcode. Examples of the electric device and the electronic device include a computer (for example, a personal computer, a smartphone, an automobile control device, a car navigation device, or the like), a television receiver, a wearable device (for example, AR/VR glasses, a smartwatch, or the like), a lighting device, and a display device (for example, a display for a computer, a large-sized display device, a large-sized vision device, an LED display device, an LED vision device). Examples of the component or member of the electric devices and the electronic devices include a flexible printed circuit board (FPC), an antenna, and a reflector.

**Claims**

1. A film comprising:

   a polyimide resin; and
   an oxide containing a boron element.

2. The film according to claim 1, wherein the oxide containing a boron element is an oxide containing a boron element and an aluminum element.

3. The film according to claim 1 or 2, wherein the oxide containing boron el ement is obtained from boric acid and alumina sol.

4. The film according to claim 1 or 2, wherein a coefficient of thermal expan sion is 50 ppm/°C or less.

5. The film according to claim 4, wherein:a light transmittance at wavelengt hs of 420 nm is 74 % or more.

6. The film according to claim 5, wherein:a yellowness index (YI) of 6.0 or less

7. The film according to claim 4, wherein a thermal conductivity is in a rang e of 0.231 W/mK or more and 0.275 W/mK or less.

8. The film according to claim 4, wherein the polyimide is obtained by imidiz ing a polyamic acid consisting of an acid dianhydride and a diamine,
   a boric acid is added to a solution of the polyamic acid in an amount with in a range of 2.0 mass% or more and 20.0 mass% or less relative to a solid content of the solution of the polyamic acid.

9. The film according to claim 8, wherein an alumina sol is further added to the solution,
   a mass ratio of a solid content of the alumina sol to the boric acid is in a r ange of 0.5 or more and 1.5 or less.

10. The film according to claim 1 or 2, wherein the blending percentage of th e boron element to the total amount is in a range of 0.5 mass% or more and 1.6 mass% or less,
    the blending percentage of the aluminum element to the total amount is i n a range of 1.5 mass% or more and 4.6 mass% or less.

11. The laminate comprising:

    the film according to claim 1 or 2, and
    a glass plate.

12. A precursor composition comprising:

    a polyamic acid;
    a boric acid;
    an alumina sol.

13. A composition for lowering the coefficient of thermal expansion of a polyi mide resin comprising: a boric acid and an alumina sol as active ingredien ts.

## INTERNATIONAL SEARCH REPORT

| International application No. |
|---|
| **PCT/JP2024/006503** |

**A. CLASSIFICATION OF SUBJECT MATTER**

*C08J 5/18*(2006.01)i; *B32B 17/10*(2006.01)i; *B32B 27/34*(2006.01)i; *C08K 3/38*(2006.01)i; *C08L 79/08*(2006.01)i; *H05K 1/03*(2006.01)i; *H05K 3/28*(2006.01)i

FI: C08J5/18 CFG; B32B17/10; B32B27/34; C08K3/38; C08L79/08 Z; H05K1/03 610N; H05K3/28 G

According to International Patent Classification (IPC) or to both national classification and IPC

**B. FIELDS SEARCHED**

Minimum documentation searched (classification system followed by classification symbols)

B32B1/00-43/00; C08J5/00-5/02; C08J5/12-5/22; C08K3/00-13/08; C08L1/00-101/14; H05K1/03; H05K3/28

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2003-113306 A (KANEGAFUCHI CHEM IND CO LTD) 18 April 2003 (2003-04-18) claims 1, 10, paragraphs [0084]-[0087], [0097]-[0100], table 1, example 5 | 1-8 |
| Y | | 11 |
| A | | 9-10, 12-13 |
| Y | JP 2020-6691 A (UNITIKA LTD.) 16 January 2020 (2020-01-16) claims, paragraph [0001] | 11 |
| Y | JP 2019-214159 A (ASAHI KASEI CORP.) 19 December 2019 (2019-12-19) claims | 11 |
| Y | JP 2020-73305 A (UNITIKA LTD.) 14 May 2020 (2020-05-14) claims, paragraph [0006] | 11 |
| A | JP 6-35630 B2 (SHIKOKU CHEMICALS CORPORATION) 11 May 1994 (1994-05-11) page 2, left column, lines 42-45 | 1-13 |

☑ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **09 May 2024** | **21 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT

| | International application No. |
| --- | --- |
| | **PCT/JP2024/006503** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2003-82231 A (KANEGAFUCHI CHEM IND CO LTD) 19 March 2003 (2003-03-19) entire text | 1-13 |
| A | JP 2012-57057 A (DIC CORP.) 22 March 2012 (2012-03-22) entire text | 1-13 |
| A | JP 2021-510388 A (PI ADVANCED MATERIALS CO., LTD.) 22 April 2021 (2021-04-22) entire text | 1-13 |

Form PCT/ISA/210 (second sheet) (July 2022)

**INTERNATIONAL SEARCH REPORT**
Information on patent family members

International application No.

**PCT/JP2024/006503**

| Patent document cited in search report | | | Publication date (day/month/year) | Patent family member(s) | | | Publication date (day/month/year) |
|---|---|---|---|---|---|---|---|
| JP | 2003-113306 | A | 18 April 2003 | (Family: none) | | | |
| JP | 2020-6691 | A | 16 January 2020 | TW | 201618943 | A | |
| | | | | KR | 10-2017-0056543 | A | |
| | | | | CN | 107073883 | A | |
| | | | | WO | 2016/043180 | A1 | |
| JP | 2019-214159 | A | 19 December 2019 | (Family: none) | | | |
| JP | 2020-73305 | A | 14 May 2020 | TW | 201634273 | A | |
| | | | | CN | 107206755 | A | |
| | | | | KR | 10-2017-0106316 | A | |
| | | | | WO | 2016/117636 | A1 | |
| JP | 6-35630 | B2 | 11 May 1994 | US | 5013523 | A | |
| | | | | column 2, lines 37-52 | | | |
| | | | | EP | 394056 | A1 | |
| JP | 2003-82231 | A | 19 March 2003 | (Family: none) | | | |
| JP | 2012-57057 | A | 22 March 2012 | (Family: none) | | | |
| JP | 2021-510388 | A | 22 April 2021 | WO | 2019/143000 | A1 | |
| | | | | KR | 10-2019-0089397 | A | |
| | | | | CN | 111630088 | A | |

Form PCT/ISA/210 (patent family annex) (July 2022)

**EP 4 674 897 A1**

**Patent documents cited in the description**

- JP 2000343610 A